Europäisches Patentamt

European Patent Office

Office européen des brevets

(11) Veröffentlichungsnummer: **0 058 756**
A1

# (12) EUROPÄISCHE PATENTANMELDUNG

(21) Anmeldenummer: **81108818.6**

(51) Int. Cl.³: **G 01 R 13/40**

(22) Anmeldetag: **23.10.81**

(30) Priorität: **26.01.81 DE 3102483**

(43) Veröffentlichungstag der Anmeldung: **01.09.82**
**Patentblatt 82/35**

(84) Benannte Vertragsstaaten: **DE FR GB**

(71) Anmelder: **SIEMENS AKTIENGESELLSCHAFT Berlin und München, Postfach 22 02 61, D-8000 München 22 (DE)**

(72) Erfinder: **Pianka, Jürgen, Dipl.-Ing., Waldmünchener Strasse 10, D-8000 München 90 (DE)**

(54) **Monolithisch integrierbare Steuerschaltung für eine nematische Anzeigeeinheit, insbesondere Balkenanzeige.**

(57) Aufgabe der Erfindung ist es, eine Steuerschaltung für eine nematische Anzeigeeinheit anzugeben, bei der die das sog. «Flackern» verursachenden Instabilitäten vermieden bzw. beseitigt sind. Hierzu ist gemäss der Erfindung die zur Beaufschlagung der – mehrere Steuerelektroden aufweisenden-Anzeigeeinheit vorgesehene Multiplexanlage ihrerseits durch informationstragende Steuersignale in Digitalform beaufschlagt. Außerdem ist die Multiplexanlage über einen taktgesteuerten Kurvengenerator zwecks Formung der Amplitude der an die Steuerelektroden der nematischen Anzeigeeinheit effektiv zu legenden Steuersignale beaufschlagt. Schließlich ist auch ein die über den Kurvengenerator einerseits und anderseits die über den die informationstragenden Steuersignale liefernden Zwischenspeicher zugeführten digitalen Steuersignale synchronisierender Schaltungsteil vorgesehen.

Siemens Aktiengesellschaft
Berlin und München

0058756

Unser Zeichen
VPA 81 P 1008 E

## Monolithisch integrierbare Steuerschaltung für eine nematische Anzeigeeinheit

Die Erfindung betrifft eine monolithisch integrierbare Steuerschaltung für eine nematische Anzeigeeinheit, bei der die Steuerung der insbesondere für eine Analoganzeige geeigneten Anzeigeeinheit im Multiplex-Betrieb erfolgt.

Für eine Analoganzeige geeignete nematische Anzeigeeinheiten sind in der Literaturstelle "Elektronik" (1978), H. 4, S. 117 - 120, dargestellt. Sie sind dort als Balkensäule-Anzeigeeinheiten bezeichnet. Die angewendete Steuerschaltung ist durch den monolithisch integrierten Baustein "LCD 365" gegeben, der von der Firma Geet GmbH geliefert und in CMOS-Technik ausgeführt ist. Hinsichtlich seiner Wirkung und Betriebsweise ist in der genannten Literaturstelle folgendes angegeben.

Ein Taktimpuls steuert die Wiedergabe der seriell wie bei einem Videosignal vorzugebenden Daten. Sie gelangen in ein Schieberegister und werden dort mit einem Strobe-Signal zur Anzeige gültig gemeldet. Die Anzahl der Speicherplätze des Schieberegisters entspricht der Anzahl der zu steuernden Informationseingänge der LCD-Anzeigeeinheit. Die letzte Stufe des Schieberegisters hat einen Datenausgang, der mit einem Ausgang der Schaltung verbunden ist, so daß beliebig viele dieser LCD 365-Bausteine kaskadiert werden können, was für umfangreiche Anzeigeeinheiten erforderlich sein kann. Der Baustein, der zugleich eine interne Serien-Parallel-Umsetzung vornimmt, ist für Taktfrequenzen (1:1) bis max. 3 MHz und für Strobe-Frequenzen (1:1) bis 500 kHz ausgelegt. Seine Ruheverlustleistung ist statisch gleich 1 mW und dynamisch gleich 10 mW/MHz sowie die Betriebsspannung max. 15 V entsprechend den Ausführungen der genannten Literaturstelle.

In dem genannten CMOS-Treiber wird durch ein gespeichertes Bit am Q-Ausgang der betreffenden Zelle des Schieberegisters das Potential an einen der in der Schaltung vorgesehenen analogen Steuereingänge geschaltet. Im übrigen wird hinsichtlich der Betriebsweise auf die genannte Literaturstelle verwiesen. Zu bemerken ist noch, daß auch die Anwendung der genannten Steuerschaltung zum Treiben von sog. Balkensäulen-Anzeigen (= Baragraphen-Anzeigen) auf S. 120 der genannten Literaturstelle im Bild dargestellt ist.

Nun tritt erfahrungsgemäß beim Betrieb der bekannten Treiberschaltungen in Verbindung mit solchen nematischen Balkensäulen-Anzeigen leicht ein Flackern des sich im eingeschalteten Zustand als auch des sich im ausgeschalteten Zustand befindlichen Teils der nematischen Anzeigeeinheit auf, sobald die Anzahl der eingeschalteten Balken geändert wird. Es ist nun Aufgabe der Erfindung eine Maßnehme anzugeben, durch deren Anwendung dieses störende Verhalten gemildert bzw. gänzlich vermieden wird.

Hierzu ist gemäß der Erfindung vorgesehen, daß die zur Beaufschlagung der mehrere Steuereinheiten aufweisenden nematischen Anzeigeeinheit vorgesehene Multiplex-Anlage einerseits durch zur Anzeigesteuerung über einen Zwischenspeicher zugeführte informationstragende digitale Steuersignale und andererseits über einen taktgesteuerten Kurvengenerator zwecks Formung der Amplitude der an die Steuerelektroden der Anzeigeeinheit effektiv zu legenden Steuersignale gesteuert ist und daß außerdem ein die über den Kurvengenerator und andererseits die über den Zwischenspeicher zugeführten Signale synchronisierender Schaltungsteil vorgesehen ist.

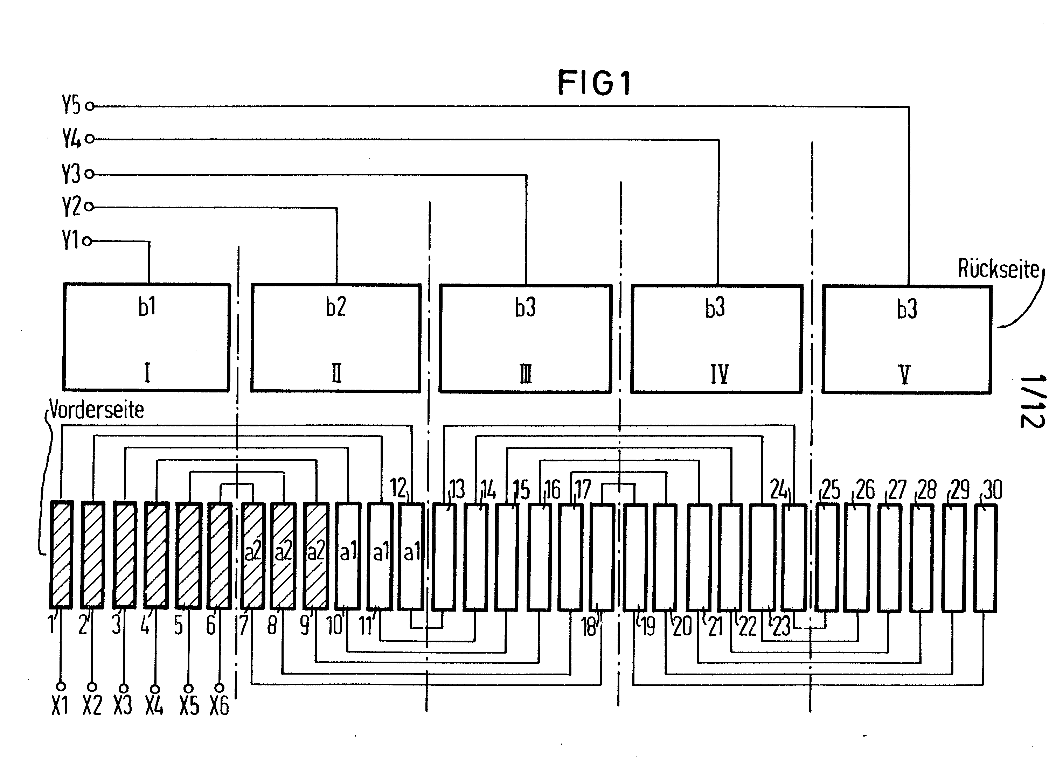

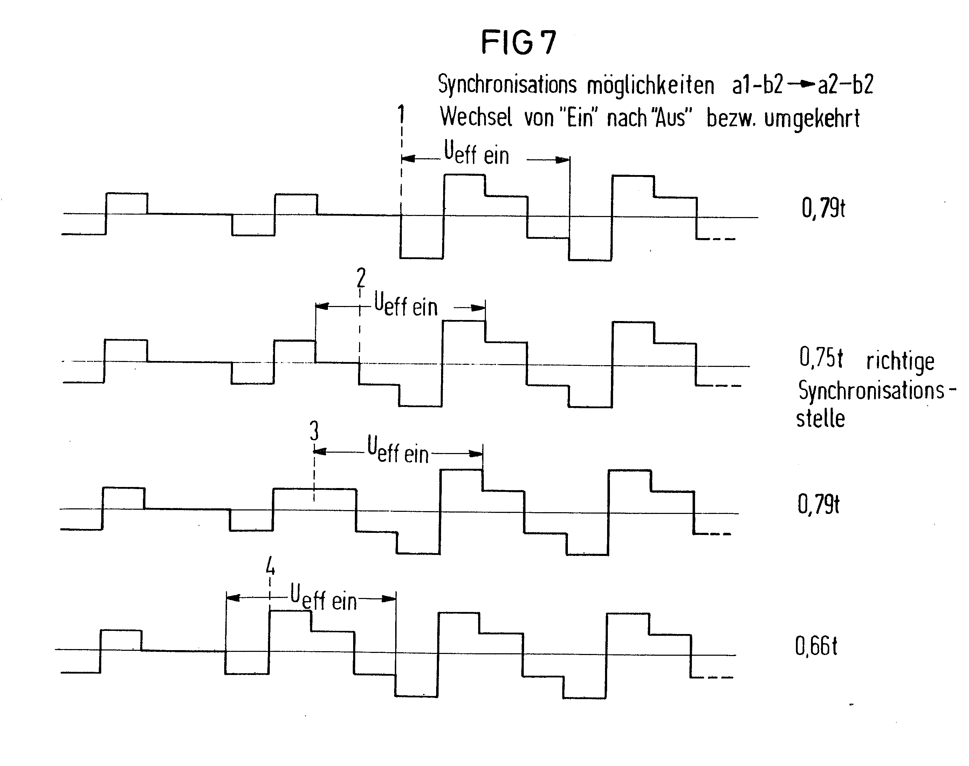

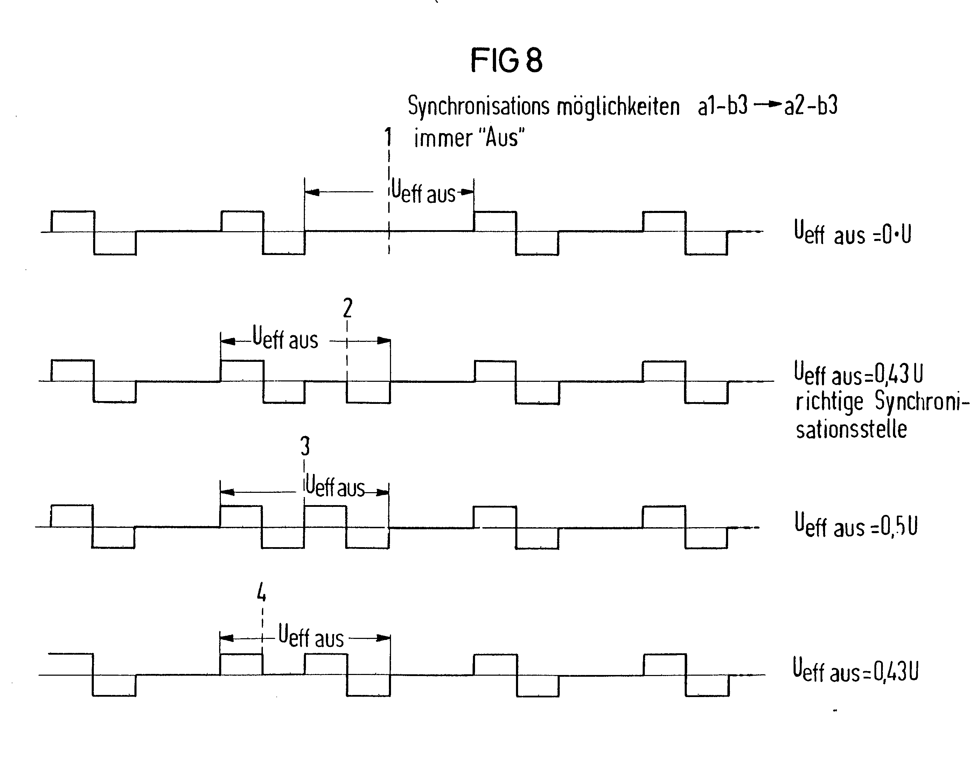

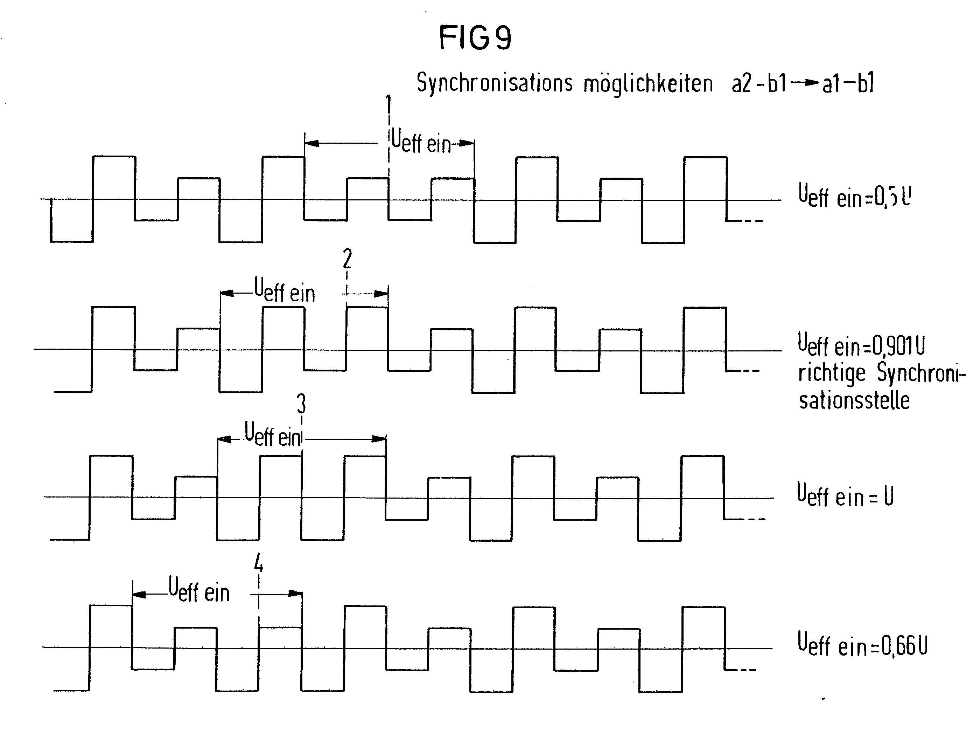

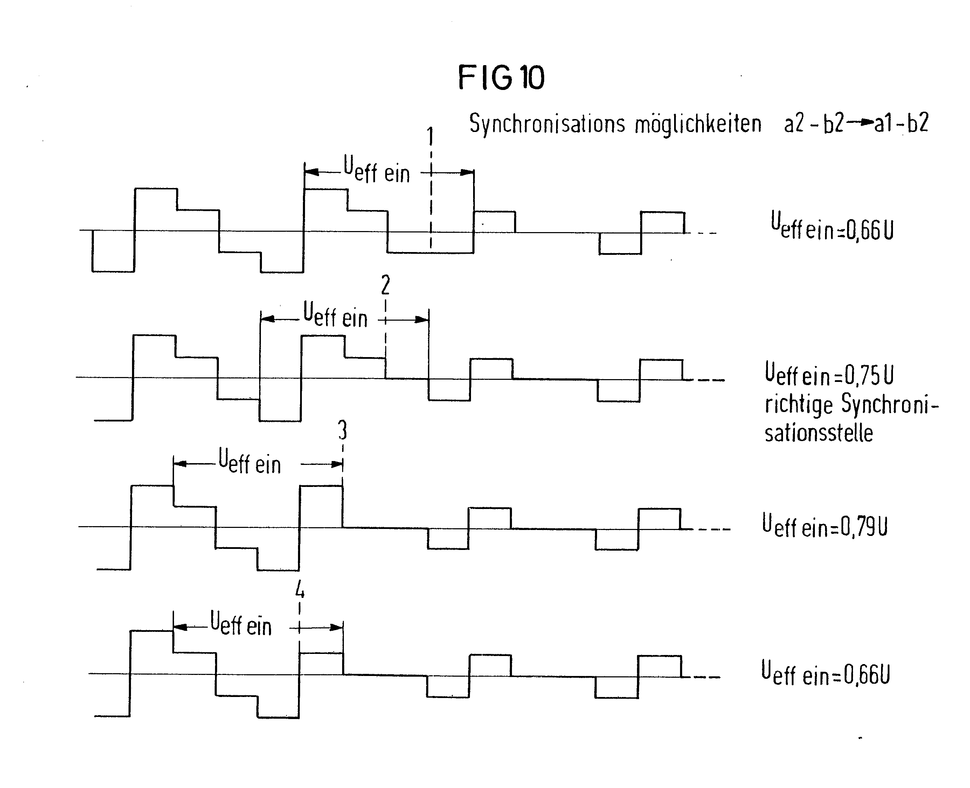

Die Erfindung wird nun anhand der Figuren 1 bis 10 näher beschrieben.

Das Ziel der Erfindung ist, den Umschaltzeitpunkt mit der Multiplexfrequenz zu synchronisieren und die Phase zwischen den zur Beaufschlagung einander zugeordneter Elektroden dienenden Signale so zu wählen, daß der effektive Spannungssprung zwischen den ihren Betriebszustand beim Übergang von der einen Betriebsphase in die nächste Betriebsphase der Anzeigeeinheit beibehaltenden Elektrodenpaaren minimal wird.

Um z.B. die Anzahl der Elektrodenanschlüsse der zu steuernden LCD-Anzeigeeinheit zu veringern.und außerdem eine angenähert analoge Anzeige über eine solche Einheit zu erhalten, hat man die bereits oben erwähnten LCD-Einheiten für Band- bzw. Balkenanzeige entwickelt, die durch ein Multiplexverfahren angesteuert werden können. Eine solche Einheit besteht aus einer mit nematischem Material gefüllten Zelle in Form eines flachen Quaders, wobei die eine Flachseite den Einblick in den nematischen Zustand der einzelnen Bereiche der Zelle ermöglicht, während an einer Schmalseite eine allen Segmenten der Anzeige gemeinsam zugeordnete und sich über diese Längsseite erstreckende sowie mit der nematischen Flüssigkeit in elektrischer Verbindung stehende Elektrode vorgesehen ist. An der gegenüberliegenden Schmalseite der Zelle ist eine Anzahl entsprechend ausgebildeter und gegeneinander isolierter Steuerelektroden vorgesehen, die jeweils ein Segment der Zelle definieren. Natürlich kann man ebenso gut statt der gemeinsamen Elektrode an der Rückseite der Zelle ebenfalls für jedes Segment je eine von den beiden Nachbarelektroden isolierte Elektrode vorsehen.

Wird nun eine monolithisch integrierte Steueranlage zur Beaufschlagung der nematischen Zelle vorgesehen, so ist man daran interessiert, die Anzahl der Steuerausgänge und damit der Pins der integrierten Schaltung aus bekannten Gründen möglichst klein zu halten. Wird die Steueranlage so ausgelegt, daß jeder Steuerelektrode der Anzeigeeinheit je ein Steuerausgang der Steueranlage zugeord-

0058756

net ist, dann kommt man bei einer solchen direkten Ansteuerung im allgemeinen auf eine große Anzahl von Steuerausgängen der integrierten Schaltung. Hat man z.B. 30
Segmente zu steuern, so braucht man bei der direkten Ansteuerung mindestens 31 Steuerausgänge.

Bei Anwendung einer Multiplexansteuerung kommt man hingegen mit einer geringeren Anzahl von Steuerpins an der
Steueranlage aus. Hat man z.B. ein Zwei-Schritt-Multiplex-Verfahren zur Ansteuerung der 30 Segmente, so benötigt man in diesem Fall nur 11 Steuerausgänge.

Die für einen solchen Fall zweckmäßige Anordnung wird
nun anhand der Figur 1 gezeigt. Dargestellt sind dabei
lediglich die an der Vorderseite der Anzeigeeinheit erforderlichen Elektroden 1 bis 30 sowie die an der Rückseite vorgesehenen fünf Elektroden I bis V, sowie die
Verbindungen dieser Elektroden untereinander bzw. mit den
Ausgängen X1- X6 bzw. Y1-Y5 der Multiplexanlage.

Wie aus Figur 1 ersichtlich, sind die 30 Elektroden
der Vorderseite der Anzeigeeinheit in Gruppen zu je sechs
Elektroden unterteilt, wobei jeder Gruppe je eine der
Elektroden I - V an der Rückseite des die nematische Flüssigkeit aufnehmenden Gehäuses der Anzeigeeinheit zugeordnet ist. In der Größe und Geometrie sind die Elektrodengruppen an der Vorderseite und die Elektroden I - V an
der Rückseite des Gehäuses so aufeinander abgestimmt,
daß die im Betriebszustand der Anlage sich zwischen den
Elektroden I bis 30 an der Vorderseite des Gehäuses und
den ElektrodenI - V an der Rückseite ausbildenden elektrischen Felder möglichst homogen sind. Die Zugehörigkeit einer bestimmten Elektrode an der Vorderseite zu
einer bestimmten Elektrodengruppe ist also durch die Anordnung der diese Elektrode mit wenigstens einer Nachbarelektrode zusammenfassenden, jeweils gegenüberliegenden
Elektrode an der Gehäuserückseite sowie der Anordnung

0058756

der besagten Elektrode an der Gehäuserückseite in der Reihenfolge dieser Elektroden I - V bestimmt.

Andererseits ist, wie aus Figur 1 ersichtlich, jeder Elektrode an der Vorderseite der Anzeigeeinheit je eine gleiche Elektrode aus jeder der vorgesehenen anderen Elektrodengruppen an der Vorderseite der Anzeigeeinheit entweder durch Serienschaltung oder durch Parallelschaltung zugeordnet, indem die auf diese Weise jeweils zusammengefaßten Elektroden an der Vorderseite des Gehäuses der Anzeigeeinheit durch denselben Ausgang der Multiplexanlage gesteuert sind. Die zur Steuerung der Elektroden 1 - 30 an der Vorderseite der Multiplexanlage vorgesehenen Steuerausgänge sind mit X1 bis X6 bezeichnet. Die Anzahl dieser Steuerausgänge entspricht somit der Anzahl der pro Gruppe von Elektroden an der Vorderseite vorgesehenen Elektroden. Hingegen ist jeder Elektrode I - V an der Rückseite der Anzeigeeinheit je ein Steuerausgang Y1 - Y5 der Multiplexanlage zugeordnet.

Bei dem in Figur 1 dargestellten Fall sind bezüglich des Steuerausgangs X1 die Elektroden 1, 7, 13, 19 und 25, bezüglich des Steuerausgangs X2 die Elektroden 1, 8, 14, 20 und 26, bezüglich des Steuerausgangs X3 die Elektroden 3, 9, 15, 21 und 27, bezüglich des Steuerausgangs X4 die Elektroden 5, 11, 17, 23 und 29 und schließlich bezüglich des Steuerausgangs X6 die Elektroden 6, 12, 18, 24 und 30 hintereinander geschaltet. Die Bezugszeichen b1 - b3 und a1, a2 werden bei der Beschreibung der Betriebsweise der erfindungsgemäßen Steuerschaltung noch definiert.

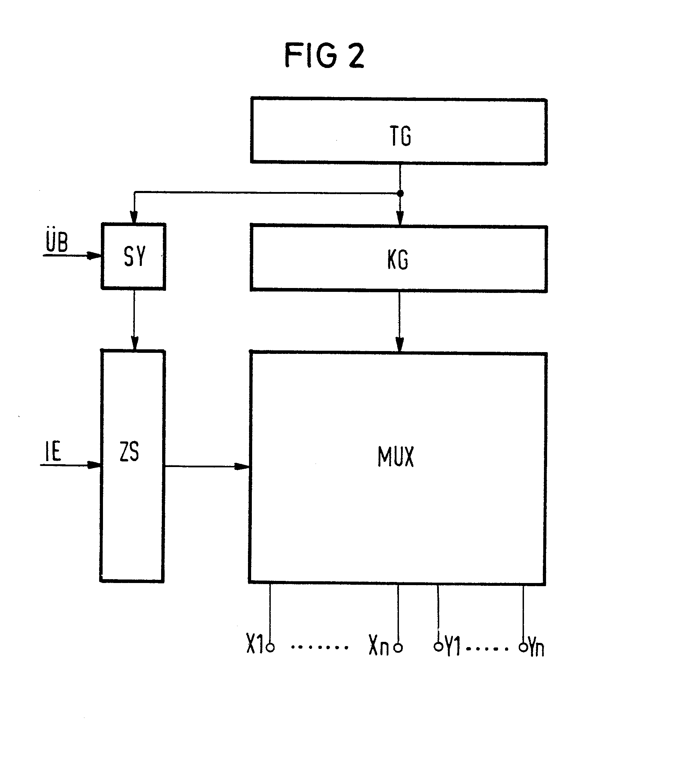

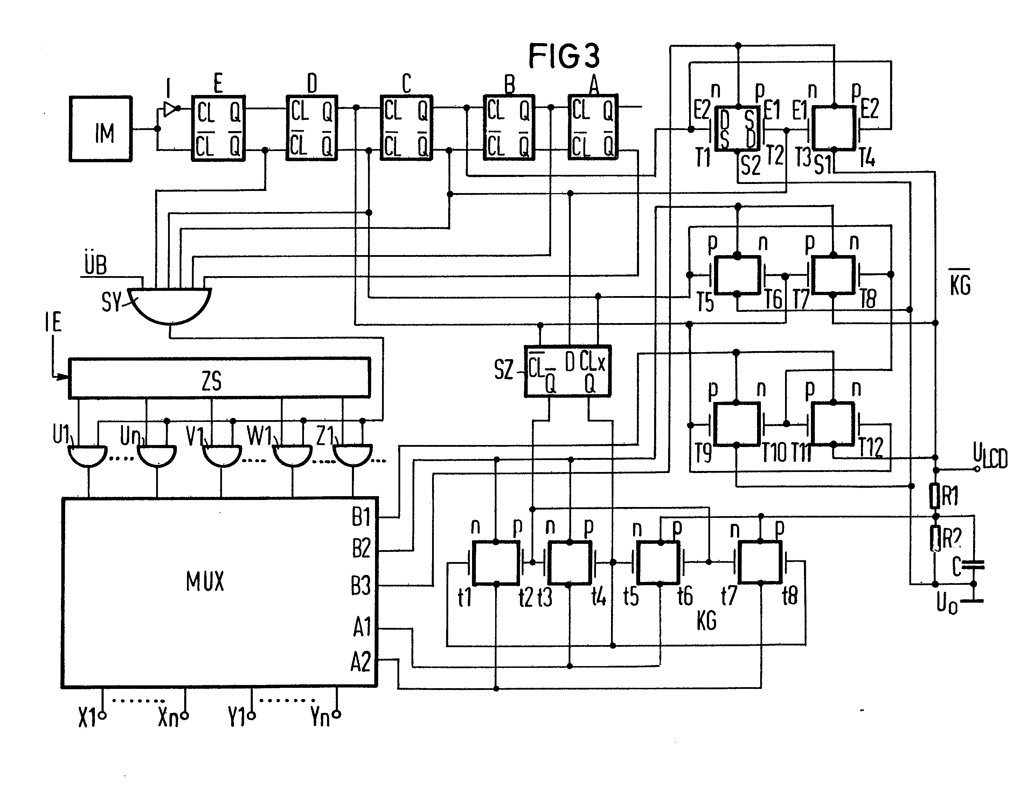

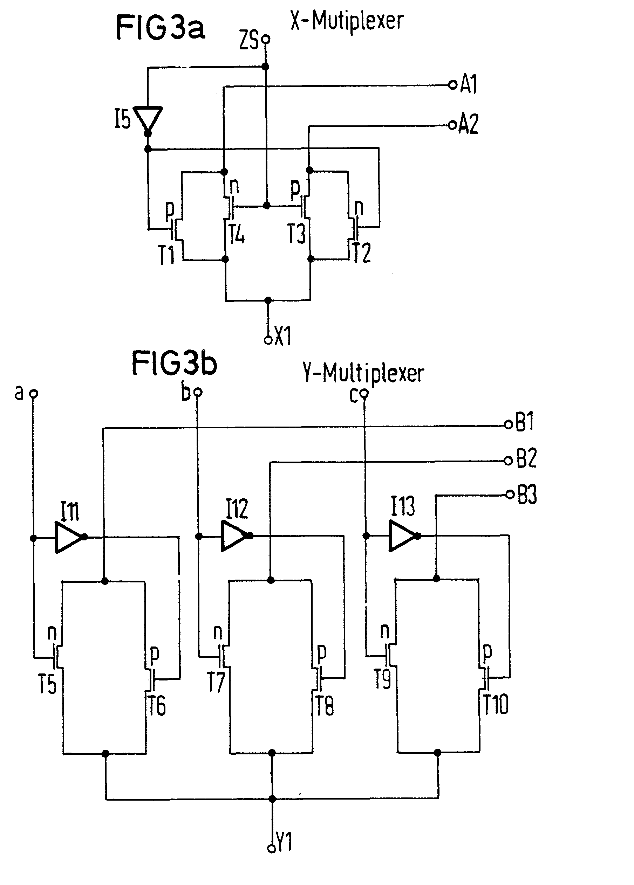

Zunächst soll die Erfindung in Figur 2 als Blockschaltbild und dann in Figur 3 in einer besonders vorteilhaften Ausgestaltung vorgestellt werden.

Im allgemeinen hat der Multiplexer MUX N zur Steuerung der Elektroden 1 bis N an der Vorderseite und M zur Steuerung der Elektroden I bis M an der Rückseite der Flüssigkristall-Anzeigeeinheit vorgesehene Steuerausgänge. Andererseits wird der Multiplexer MUX insbesondere im Parallelbetrieb durch die über einen Zwischenspeicher ZS eingegebene und über die nematische Anzeigeeinheit zur Anzeige zu bringende Information beaufschlagt. Der Informationseingang der Anlage ist mit IE bezeichnet. Weiterhing hat der Multiplexer MUX weitere Steuereingänge, die vom Kruvengenerator KG beaufschlagt sind. Ein Taktgenerator TG steuert einerseits den Kurvengenerator KG und andererseits mit der gleichen Taktfolge die Symmetrieranlage SY, die ihrerseits dafür sorgt, daß beim Auftreten eines die Übernahme steuernden Signals ÜB die jeweils im Zwischenspeicher anhängige digitale Information zugleich mit der zugehörigen Information aus dem Kurvengenerator KG in den Multiplexer MUX gelangt.

Der Multiplexer MUX ordnet somit den Ausgängen X1 bis XN bzw. Y1 bis YM die vom Kurvengenerator KG gelieferten Kurvenformen entsprechend der Information des Zwischenspeichers ZS zu. Der Taktgeber TG dient der Vorgabe des zum Betrieb der Steueranlage erforderlichen Zeitrasters. Die Synchronisierungsstufe SY hat die Aufgabe, die durch einen Übernahmeimpuls ÜB ausgelöste Übernahme in das durch den Taktgenerator TG vorgegebene Zeitraster zu synchronisieren. Aufgabe des Kurvengenerators KG ist es, aus der Versorgungsspannung der Anlage die an die Steuerelektroden X1 bis XN einerseits und an die Steuerelektroden Y1 bis YM andererseits zu legenden Steuerspannungen zur Beaufschlagung der LCD-Anzeigeeinheit zu liefern.

Die detaillierte Ausführung einer Steueranlage gemäß Figur 2 wird bevorzugt in der aus Figur 3 ersichtlichen Weise vorgenommen.

Bei dieser besteht der Taktgeber TG aus einem Impulsgeber IM mit einer nachgeschalteten Teilerkette. Der Impulsgeber IM ist bevorzugt in an sich bekannter Weise als RC-
Oszillator, z.B. mit einer Oszillatorfrequenz von
15oo Hz, ausgestaltet. Die einzelnen Teilerstufen E, D,
C, B, A der Teilerkette sind durch Master-Slave-Flip-
Flops gegeben, wobei das erste Flip-Flop durch den die
Rechteck-Taktimpulse CL (CL = clock) liefernden Ausgang
des Oszillators IM an seinem $\overline{CL}$-Eingang unmittelbar und
an seinem CL-Eingang über einen Inverter I mit den Betriebsimpulsen versorgt ist. Im Beispielsfalle besteht
die Teilerkette aus fünf hintereinander geschalteten
getakteten Flip-Flops, insbesondere Master-Slave-Flip-
Flops, E, D, C, B und A, wobei der das invertierte Signal führende Ausgang $\overline{Q}$ des ersten Flip-Flops E der Teilerkette zusätzlich an einen der Steuereingänge eines
den Synchronisierer SY bildenden logischen Gatters liegt.

Ein weiterer Steuereingang des Synchronisierers SY ist
mit dem invertierenden Ausgang $\overline{Q}$ des zweiten Flip-Flops
D, ein dritter Steuereingang von SY mit dem invertierenden Ausgang $\overline{Q}$ des dritten Flip-Flops C, ein vierter Steuereingang des Gatters SY mit dem invertierenden Ausgang
$\overline{Q}$ der vierten Teilerstufe B und schließlich der invertierende Ausgang $\overline{Q}$ der letzten Flip-Flopzelle A des Teilers
mit einem fünften Steuereingang des Synchronisierers SY
leitend verbunden. Ein letzter Steuereingang des Synchroni-
sier-Gatters SY wird von den Übernahmeimpulsen ÜB beaufschlagt, die von dem mit der Anzeigeeinheit verbundenen
elektronischen Gerät, z.B. einer elektronischen UHR, geliefert werden.

Im Beispielsfalle ist der Synchronisierer durch ein
UND-Gatter mit sechs Signaleingängen gegeben.

Der Signalausgang der Synchronisierstufe SY liegt an je
einem Eingang einer Anzahl von UND-Gattern. Diese weiteren UND-Gatter U1, U2,...UN,bzw. V1, V2,...VM,bzw. W1,
W2,...WM, bzw. Z1, Z2,...ZM weisen jeweils zwei Signaleingänge auf, wobei jeweils der eine Eingang durch den Synchronisierer SY und mit ihrem zweiten Eingang jeweils je einem der Informationsausgänge des bereits in Figur 1 dargestellten Zwischenspeichers ZS zugeordnet sind, so daß beim Erscheinen eines Übernahmesignals am Ausgang des Synchronisierers SY die in ihm jeweils gespeicherte Information in den Multiplexer MUX gelangt.

Der Zwischenspeicher ZS ist entweder als Parallel-Parallel-Wandler oder bevorzugt als Serien-Parallel-Wandler ausgebildet. In diesem Falle besteht er aus einem taktgesteuerten Schieberegister, in das die auszuwertende und anzuzeigende Information. digital über dessen Informationseingang IE eingeschoben und dann bei einem Übernahmetakt ÜB an den Synchronisierer SY aus dem Zwischenspeicher ZS in den Multiplexer MUX gelangt.

Der Taktgeber TG ist außerdem zur Steuerung des Kurvenformers KG vorgesehen. Dieser besteht aus einem ersten zur Beaufschlagung der Elektroden an der Vorderseite der nematischen Anzeigeeinheit zugeteilten Ausgängen X1 bis XN des Multiplexers MUX dienenden Teil und einem zweiten zur Beaufschlagung der an der Rückseite der nematischen Zelle vorgesehenen Elektroden I bis V dienenden Teil.

Der das erste Betriebspotential $U_{LCD}$ führende Versorgungseingang für die LCD-Anlage liegt über einen aus zwei Widerständen R1 und R2 bestehenden Spannungsteiler am Bezugspotential $U_o$, wobei die Spannung durch den Teilerpunkt zwischen den beiden Widerständen R1 und R2 halbiert wird. Der am Bezugspotential $U_o$ liegende Widerstand R2 des Spannungsteilers ist außerdem durch einen Kondensator C überbrückt, um die halbierte Spannung zu stützen.

Der für die Beaufschlagung der an der Rückseite der LCD-Anzeigeeinheit liegenden Elektroden I bis V über den Multiplexer MUX zuständige Teil des Kurvengenerators KG enthält als wesentlichen Bestandteil zwölf MOS-Feldeffekt-transistoren vom Anreicherungstyp, von denen die Hälfte vom n-Kanaltyp und der Rest vom p-Kanaltyp ist. Außerdem ist jeder dieser n-Kanaltransistoren mit je einem der p-Kanaltransistoren durch Verbindung ihrer stromführenden Anschlüsse zu je einem Transistorpaar zusammengefaßt.

Das aus dem n-Kanaltransistor T1 und dem p-Kanaltransistor T2 bestehende erste Transistorpaar des Kurvengenerators KG liegt mit seinen Sourceanschlüssen am Bezugspotential $U_o$ und ist mit seinen Drainanschlüssen mit den Sourceanschlüssen der das zweite Transistorpaar bildenden Transistoren T3 und T4 verbunden. Die Drains der Transistoren T3 und T4 liegen am Betriebspotential $U_{LCD}$. Die Gates des p-Kanaltransistors T2 und des n-Kanaltransistors T3 einerseits werden durch den invertierenden Ausgang $\overline{Q}$ der vierten Teilerzelle C im Taktgenerator TG und die Gates des n-Kanaltransistors T1 und des p-Kanaltransistors T4 andererseits werden durch den nichtinvertierenden Ausgang Q der besagten Teilerstufe C gesteuert. Schließlich ist zwischen den Drains der Transistoren T1 und T2 und den Sourceanschlüssen der Transistoren T3 und T4 ein Signal B3 abnehmbar, das zur Steuerung des Multiplexers MUX über dessen Eingang B3 in dem bereits angegebenen Sinn vorgesehen ist.

Das dritte Transistorpaar besteht aus dem p-Kanaltransistor T5 und dem n-Kanaltransistor T6 während das vierte Transistorpaar durch den p-Kanaltransistor T7 und den n-Kanaltransistor T8 gebildet ist. Dabei liegen die Sourceanschlüsse des dritten Transistorpaars T5, T6 wiederum am Bezugspotential $U_o$ während die Drainanschlüsse dieses Transistorpaars an die Sourceanschlüsse des vierten Transistorpaares T7, T8 gekoppelt sind und zusammen mit diesen ein weiteres zur Steuerung des Multiplexers MUX dienendes Signal B2 liefern. Die Drains des vierten Transistorpaares T7, T8 sind mit den Drains des zweiten Transistorpaares T3, T4 verbunden und liegen daher am Potential $U_{LCD}$.

Das fünfte Transistorpaar besteht aus dem p-Kanaltransistor T9 und dem n-Kanaltransistor T10 und das sechste Transistorpaar aus dem p-Kanaltransistor T11 und dem n-Kanaltransistor T12. Die Sourceanschlüsse des fünften Transistorpaars T9 und T10 liegen wiederum am Bezugspotential $U_o$ und die Drains des sechsten Transistorpaares T11, T12 wiederum am ersten Betriebspotential $U_{LCD}$. Andererseits sind die Drainanschlüsse des fünften Transistorpaares T9 und T10 an die Sourceanschlüsse des sechsten Transistorpaares T11 und T12 gelegt und bestimmen zusammen mit diesen ein weiters der Beaufschlagung des Multiplexers MUX dienendes Signal B1.

Die Gates des dritten und vierten Transistorpaars T5, T6 bzw. T7, T8 sowie die Gates des fünften und sechsten Transistorpaares T9, T10 bzw. T11, T12 werden von den Ausgängen der zweiten Stufe D des Frequenzteilers im Taktgenerator TG gesteuert. Hierzu liegen die Gates der Transistoren T6, T7 und T9, T10 unmittelbar am nichtinvertierenden Ausgang, also dem Q-Ausgang, der besagten Teilerstufe D, während die Gates der Transistoren T5, T8, T10 und T11 unmittelbar mit dem invertierenden Ausgang $\bar{Q}$ der besagten Teilerstufe D verbunden sind.

Der über den Multiplexer MUX zur Beaufschlagung der Elektroden an der Vorderseite der LCD-Anlage - d.h. also der Multiplexer-Ausgänge X1 - XN dienende Teil des Kurvengenerators KG enthält die MOS-Feldeffekttransistoren t1 bis t8, von denen vier vom n-Kanaltyp und vier vom p-Kanaltyp sind. Außerdem handelt es sich auch hier um selbstsperrende Transistoren, also um Transistoren vom Anreicherungstyp. Dabei sind die Transistoren t1, t3, t5 und t7 vom n-Kanaltyp und die Transistoren t2, t4, t6 und t8 vom p-Kanaltyp. Auch hier sind wiederum die einzelnen n-Kanaltransistoren mit je einem der p-Kanaltransistoren zu je einem Transistorpaar zusammengefaßt, indem die die einzelnen Transistorpaare bildenden Transistoren über ihre Sourceanschlüsse als auch über ihre Drainanschlüsse miteinander verbunden sind.

Eine, z.B. durch ein getaktetes D-Flip-Flop gegebene Schieberegisterzelle SZ liegt mit ihrem Dateneingang D am invertierenden Ausgang $\overline{Q}$ der dritten Stufe C und mit ihrem Takteingang CL am invertierenden Ausgang $\overline{Q}$ der zweiten Stufe D des Frequenzteilers im Taktgenerator TG. Die beiden Ausgänge Q und $\overline{Q}$ dieser Schieberegisterzelle SZ dienen der Steuerung der Gates der Transistoren t1 bis t8 in dem - nunmehr schaltungsmäßig weiter zu beschreibenden - zweiten Teil des Kurvengenerators KG.

Der Transistor t1 und der mit ihm zusammengefaßte Transistor t2 liegen mit ihren Drains an den Drains des zweiten Transistorpaars t3 und t4 sowie an einem Schaltungspunkt zwischen den Drains des dritten Transistorpaares T5, T6 und den Sourceanschlüssen des vierten Transistorpaares T7, T8 im ersten Teil des Kurvengenerators KG. Sie werden somit bezüglich ihrer Source-Drainstrecken in Reihe mit den besagten Transistoren T5 bis T8 des ersten Teiles des Kurvengenerators KG durch das Signal B2 beaufschlagt. Der andere stromführende Anschluß des Transistorpaares t1 und t2 im zweiten Teil des Kurvengenerators KG liefert zusammen mit dem noch zu beschreibenden Transistorpaar t7, t8 ein der Steuerung des Multiplexers MUX dienendes Steuersignal A2.

Das zweite Transistorpaar aus dem n-Kanaltransistor t3 und dem p-Kanaltransistor t4 ist bezüglich seiner Drainanschlüsse mit den entsprechenden Anschlüssen des ersten Transistorpaars t3, t4 des zweiten Teils des Kurvengenerators KG verbunden und wird demgemäß ebenfalls durch das Signal B2 aus dem ersten Teil des Kurvengenerators KG ver-

0058756

sorgt. Es liefert außerdem zusammen mit dem dritten Transistorpaar t5, t6 des zweiten Teiles des Kurvengenerators KG ein weiteres der Steuerung des Multiplexers MUX dienendes Signal A1.

Das dritte Transistorpaar t5, t6 im zweiten Teil des Kurvengenerators KG besteht aus dem n-Kanaltransistor t5 und dem p-Kanaltransistor t6. Die beiden Transistoren t5 und t6 liegen mit ihrer Source-Drainstrecke einerseits an dem Teilerpunkt des bereits erwähnten Spannungsteilers R1, R2 und liefern andererseits zusammen mit dem zweiten Transistorpaar t3, t4das bereits erwähnte Steuersignal A1 für den Multiplexer MUX. '

Das vierte Transistorpaar wird von dem n-Kanaltransistor t7 und dem p-Kanaltransistor t8 gebildet. Die Drains dieses Transistorpaars liegen wieder am Teilerpunkt des besagten Spannungsteilers R1, R2, während seine Sourceanschlüsse mit den den Drainanschlüssen des ersten Transistorpaars t1, t2 im zweiten Teil von KG verbunden sind und gemeinsam mit diesen das bereits erwähnte Steuersignal A2 für den Multiplexer MUX liefern.

Hinsichtlich der Steuerung der Gates der Transistoren t1 bis t8 im zweiten Teil des Kurvengenerators KG sind die beiden Ausgänge Q und $\overline{Q}'$der bereits erwähnten taktgesteuerten Schieberegisterzelle SZ verantwortlich. Hierzu liegen die Gates der Transistoren t1, t4, t5 und t8 am direkten Ausgang Q und die Gates der Transistoren t2, t3, t6 und t7 am invertierenden Ausgang $\overline{Q}$ der Schieberegisterzelle SZ.

Das an dem invertierenden Ausgang $\overline{Q}$ der ersten Teilerstufe E auftretende Signal E$\overline{Q}$, die an den Ausgängen der zweiten Teilerstufe D auftretenden Signale DQ und D$\overline{Q}$, die an den Ausgängen der dritten Teilerstufe C auftretenden Signale CQ und C$\overline{Q}$ und die an den beiden Ausgängen der vierten

0058756
VPA 81 P 1008 E

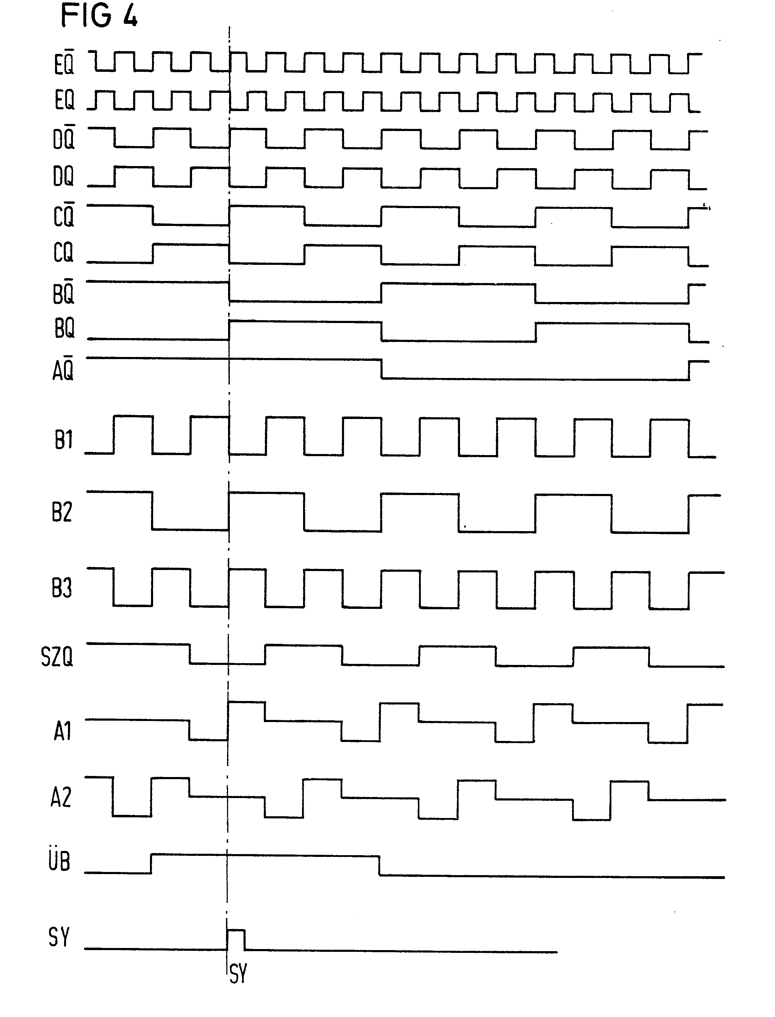

Teilerstufe B anfallenden Signale BQ und $\overline{BQ}$ sind im Zeitdiagramm in Figur 4 dargestellt, ebenso wie das von der fünften Teilerstufe A am invertierenden Ausgang $\overline{Q}$ auftretende Signal. Das am direkten Ausgang Q der fünften Teilerstufe A gelieferte Signal wird, wie aus Fig.3 ersichtlich, nicht ausgewertet. Der Signalhub ist bei allen bisherigen Signalen gleich und entspricht dem Unterschied der beiden logischen Pegel "0" und "1". Als Abszisse ist in Figur 4 die Zeit·t im linearen Maßstab verwendet.

In Figur 4 sind ferner die Signale B1, B2,B3 sowie die Signale A1 und A2 dargestellt, wie sie aufgrund der in Figur 3 dargestellten Schaltung des Kurvengenerators KG geliefert werden. Ferner ist das vom Synchronisierer SY gelieferte Synchronisiersignal, das am nichtinvertierenden Ausgang $\overline{Q}$ der Schieberegisterzelle SZ auftretende Signal SZQ sowie der Übernahmeimpuls dargestellt.

Es ist möglich, die in Figur 3 dargestellte Schaltung auch in Ein-Kanaltechnik, z.B. in n-Kanaltechnik zu realisieren. Andererseits kann man auch den Taktgenerator TG, den Synchronisierer SY sowie auch den Multiplexer MUX in CMOS-Technik realisieren. Eine hierzu geeignete Schaltung ist in Fig. 3a und in Fig. 3b gezeichnet. Dabei bezieht sich die Figur 3a auf den der Beaufschlagung der Elektroden an der Vorderseite der LCD-Anzeigeeinheit dienenden Teil des Multiplexers MUX und die Darstellung gemäß Fig. 3b auf den der Beaufschlagung der Elektroden an der Rückseite. In Fig. 3 hingegen ist der Multiplexer nur als Block dargestellt. Zu sagen ist, daß die vom ersten Teil des Kurvengenerators KG, also den Transistoren T1- T12 gelieferten Signale B1, B2 und B3 für die Beaufschlagung der Multiplexausgänge Y1 bis YM und die vom zweiten Teil des Kurvengenerators KG gelieferten Signale A1 und A2 zur Beaufschlagung der Multiplexausgänge X1 bis XN vorgesehen sind.

Ferner erkennt man aus Figur 3, daß die Informationsübergabe aus dem Zwischenspeicher ZS in den Multiplexer MUX über die bereits erwähnten UND-Gatter U1, U2,..UN, V1, V2,...VM, W;, W2,....WM und Z1, Z2,..ZM erfolgt. Jedem dieser (N+3M) UND-Gatter ist je eine der hintereinander angeordneten Speicherzellen des Zwischenspeicher ZS zugeordnet. Dabei führen die N UND-Gatter U1 bis UN die zur Steuerung der N Ausgänge X1 bis XN dienende Digitalinformation in Form je eines Bits und die restlichen 3M UND-Gatter V1..VM, W1,...Wm, Z1,..ZM die zur Steerung der Y-Ausgänge des Multiplexers MUX dienende Information.

Die in Figur 3a und Fig. 3b dargestellte Schaltung für je einen der N X-Ausgänge bzw. der M Y-Ausgänge des Multiplexers MUX ist ebenso wie die Ausgestaltung des Kurvengenerators KG in CMOS-Technik gegeben, wobei wieder jeweils ein n-Kanaltransistor mit je einem p-Kanaltransistor zu einem Schalttransistorpaar kombiniert ist, indem die stromführenden Anschlüsse der zu kombinierenden komplementären MOS-Feldeffekttransistoren in der bereits anhand von Fig. 3 gezeigten Weise miteinander verbunden werden.

Bei der aus Fig. 3a ersichtlichen Ausgestaltung eines je einem der Ausgänge X1,...XN zugeordneten Schaltungsteils des Multiplexers MUX wird der Signaleingang durch je eines der vorgesehenen UND-Gatter U1 bis UN und damit durch je einen der informationsliefernden Ausgänge des Zwischenspeichers ZS beaufschlagt, und zwar immer dann, wenn am Ausgang des Synchronisierers SY ein Übergabesignal erscheint. Der Ausgang des besagten UND-Gatters steuert über einen gemeinsamen Inverter 5 das Gate eines p-Kanal-MOS-Transistors 1 und eines n-Kanal-MOS-Transistors 4. Andererseits liegt der Ausgang des besagten UND-Gatters U1,..UN unmittelbar an dem Gate eines weiteren n-Kanaltransistors 2 und eines weiteren p-Kanaltransistors 3. Die Sourceanschlüsse der genannten vier MOS-Feldeffekttransistoren (vom Anreicherungstyp) 1 bis 4 sind zu je einem der X-Ausgänge des Multiplexers MUX, also zu je einem der Ausgänge X1 bis XN zusammengefaßt. Das vom Kurvengenerator KG gelieferte Signal A1 liegt dabei am Drain des durch den Inverter 5 gesteuerten p-Kanaltransistors 1 und des unmittelbar von dem besagten UND-Gatter gesteuerten n-Kanaltransistors 2. Anderseits liegt das vom Kurvengenerator KG gelieferte Signal A2 am Drain des unmittelbar von dem UND-Gatter gesteuerten p-Kanaltransistors 3 und des über den Inverter 5 gesteuerten n-Kanaltransistors 4.

Die zur Steuerung je eines der vorgesehenen Y-Ausgänge Y1 bis YM vorgesehene Teilanlage des Multiplexers MUX gemäß Figur 3 besteht ebenfalls wie die zur Steuerung der X-Ausgänge dienende Teilanlage aus je einem Ausgang zugeordneten Zellen, von denen eine in Figur 3 b dargestellt ist. Jede dieser Zellen hat drei durch je ein UND-Gatter V1 bis VM bzw. W1 bis WM bzw. Z1 bis ZM beaufschlagte Informationseingänge a bzw. b bzw. c. Der Informationseingang a ist unmittelbar mit dem Gate eines n-Kanaltransistors 5 und über einen Inverter 11 mit dem Gate eines p-Kanaltransistors 6 verbunden. Die beiden Transistoren 5 und 6 werden über ihre Drains von dem vom ersten Teil des Kurvengenerators KG gelieferten Signal beaufschlagt. Ein weiteres Transistorpaar aus einem n-Kanaltransistor 7 und einem p-Kanaltransistor 8 wird über den durch eines der UND-Gatter V beaufschlagten Informationseingang gesteuert und zwar derart, daß der n-Kanaltransistor 7 unmittelbar und der p-Kanaltransistor 8 unter Vermittlung eines Inverters 12 beaufschlagt ist. An den Drains dieser beiden Transistoren 7 und 8 liegt das vom Kurvengenerator KG gelieferte Signal B2. Der dritte der betrachteten Schaltungseinheit zugeordnete und von je einem der M UND-Gatter Z1 bis ZM beaufschlagte Informationseingang c liegt am Gate eines dritten n-Kanaltransistors 9 und über einen Inverter 13 am Gate eines dritten p-Kanaltransistors 10. An den Drains dieser beiden Transistoren 9 und 10 wird das dritte vom ersten Teil des Kurvengenerators KG gelieferte Steuersignal B3 gegeben. In entsprechender Weise wie bei der in Figur 3a dargestellten Zelle im Umschaltungsteil des Multiplexers für die X-Ausgänge sind auch hier die Drainanschlüsse sämtlicher Transistoren 5 bis 10 zu je einem der Ausgänge Y1 bis YM zusammengefaßt.

Im Hinblick auf die aus Fig. 3b bzw. Fig. 3 ersichtliche Ausgestaltung des Multiplexers MUX ist noch zu bemerken, daß die zur Steuerung des Multiplexers MUX über den Zwischenspeicher ZS zugeführte digitale Information so beschaffen sein muß, daß nicht gleichzeitig an zweien der drei Eingänge a, b und c eine "1" anhängig ist.

Die Verwendung komplementärer MOS-Feldeffekttransistoren vom Anreicherungstyp führt bekanntlich zu einem merklich geringeren Energiebedarf der Schaltung im Vergleich zu einer Realisierung in Einkanaltechnik. Aus diesem Grunde empfiehtl es sich, auch die übrigen Schaltungsteile, d.h. den Taktgenerator TG, den Synchronissierer SY sowie den Zwischenspeicher ZS in CMOS-Technik zu realisieren. So findet man z.B. Beispiele für eine CMOS-Ausführung eines Schieberegisters und von Flip-Flopzelle in "Proc. IEEE" (July 1971), S. 1053 - 1055.

Die anhand der Figuren 3, 3a und 3b beschriebene Ausgestaltung einer Steuerung für eine LCD-Balkenanzeigeeinheit arbeitet nach dem sog. Zweischritt-Multiplexverfahren. Dieses führt dazu, daß unterschiedliche Spannungskurvenformen entsprechend den Signalen A1, A2, B1, B2 und B3 an die Elektroden der Vorderseite bzw. an die Elektroden an der Rückseite der LCD-Balkenanzeigeeinheit gelegt werden.

Das für den Betrieb einer Anlage gemäß Figur 1 bis 3b sich ergebende Signalprogramm ist, wie bereits oben angedeutet, in Figur 4 dargestellt. Dabei dient die

0058756

Zeit t als Abszisse und der Signalpegel als Ordinate. Zusammenfassend und ergänzend zu den bereits gemachten Aussagen zu Figur 4 wird bemerkt, daß die Signale folgende Bedeutung haben:

$E\overline{Q}$ und EQ = Signal an dem invertierenden bzs. nichtinvertierenden Ausgang der ersten Teilerstufe E des Taktgenerators TG

$D\overline{Q}$ und DQ = Signal am invertierenden bzw. nichtinvertierenden Ausgang der zweiten Teilerstufe D.

$C\overline{Q}$ und CQ = Signal am invertierenden bzw. nichtinvertierenden Ausgang der dritten Teilerstufe C

$B\overline{Q}$ und BQ = Signal am invertierenden bzw. nichtinvertierenden Ausgang der vierten Teilerstufe B.

$A\overline{Q}$ = Signal am invertierenden Ausgang der fünften Teilerstufe A des Taktgenerators TG.

Die bisher genannten Signale haben den Pegel logisch "0" und logisch "1", der durch die Spannungsbeaufschlagung und die Bemessung der Schaltungsteile des Taktgebers TG festgelegt ist. Hingegen leiten sich die Amplituden der Signale B1 bis A2 von der durch das Bezugspotential $U_o$ und dem für die LCD-Anlage vorgesehenen ersten Betriebspotential $U_{LCD}$ ab, wobei die Spannungsdifferenz $U_{LCD}-U_o$ an dem besagten Spannungsteiler R1, R2 in Fig. 3 liegt. Demgemäß ist diese Spannungsdifferenz für die Einstellung der Signale A1, A2, B1, B2 und B3 verbindlich. Durch das digitale Übernahmesignal ÜB, das von der informationsliefernden Anlage mitgeliefert wird, wird der Synchronisierungsvorgang eingeleitet. Aus diesem Grund ist es erforderlich, das Übernahmesignal ÜB solange anhängig zu lassen, bis der Snchronisierer SY angesprochen hat. Dies ist dann der Fall, wenn der zur Beaufschlagung des Synchronisierers für dessen Ansprechen
erforderliche Betriebszustand in der Teilerkette des
Taktgenerators TG realisiert ist. Es empfiehlt sich,
entweder den Synchronisierer in Ein-Kanaltechnik als
UND-Gatter oder durch ein CMOS-NAND-Gatter mit anschließendem CMOS-Inverter zu realisieren.

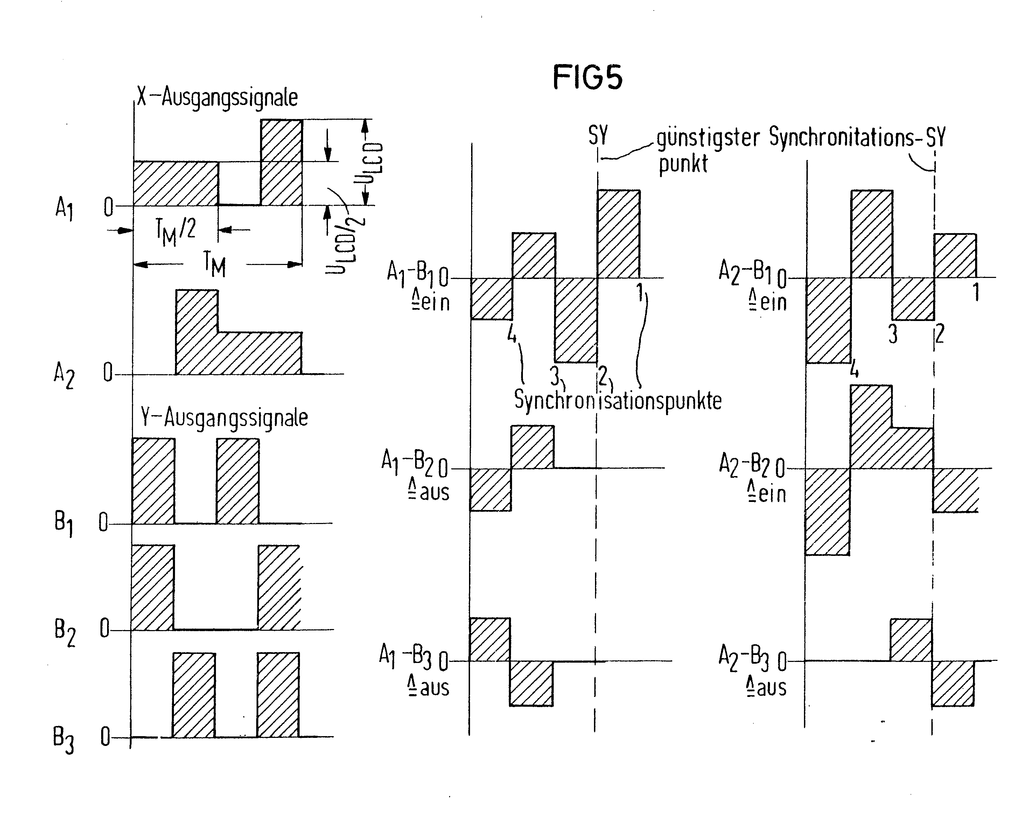

Die verschiedenen im Zweischritt Multiplexverfahren
möglichen und durch die Spannungsdifferenzen gebildeten
Wechselspannungen sind in Figur 5 dargestellt, aus der
auch die für die Synchronisierung günstigen Zeitpunkte
ersichtlich sind.

Bei sich nichtändernder Anzeige auf der LCD-Balkenanzeige
wiederholen sich die Spannungskurven periodisch. Das bedeutet, daß die Effektivwerte der Spannungsdifferenzen
für den Zustand "EIN" und den Zustand "AUS" konstant sind.
In dem beschriebenen Ausführungsbeispiel hat man für die
effektive Spannung $U_{eff}$ für den eingeschalteten Zustand
die Beziehung

$$U_{eff\ EIN} = ((U^2t/4) + 2\ U^2t) : 4t)^{1/2} =$$
$$= 0{,}79\ (U_{LCD} - U_o),$$

und für den ausgeschalteten Zustand

$$U_{eff\ AUS} = ((U^2t/2) : 4t)^{1/2} =$$
$$= 0{,}353\ (U_{LCD} - U_o).$$

Damit beträgt der Hub $S = U_{eff\ EIN} : U_{eff\ AUS} = 2{,}23$
(Fall 1.1).

Bei sich ändernder Anzeige auf dem LCD müssen auch die
angelegten Spannungen geändert werden. Beispielsweise
geht hier die Signaldifferenz (A1 - B1) nach (A2 - B1),
von (A1 - B2) nach (A2 - B2) und von (A1 - B3) nach
(A2 - B3) oder umgekehrt von (A2 - B1) nach (A1 - B1),
von (A2 - B2) nach (A1 - B2) und von (A2 - B3) nach (A1 - B3).

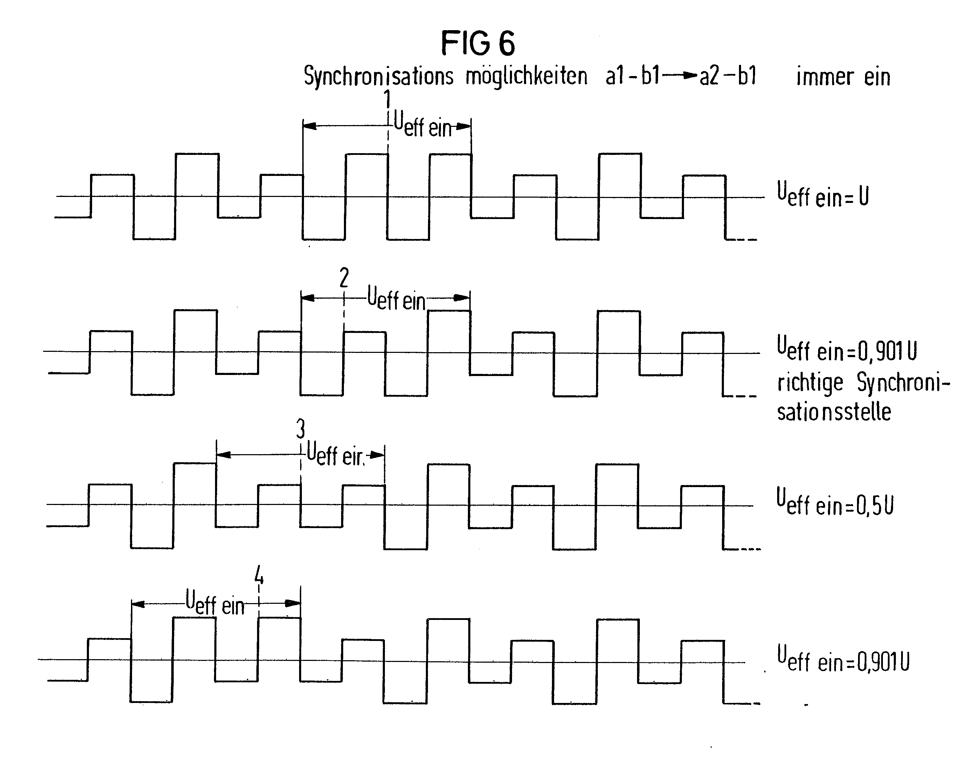

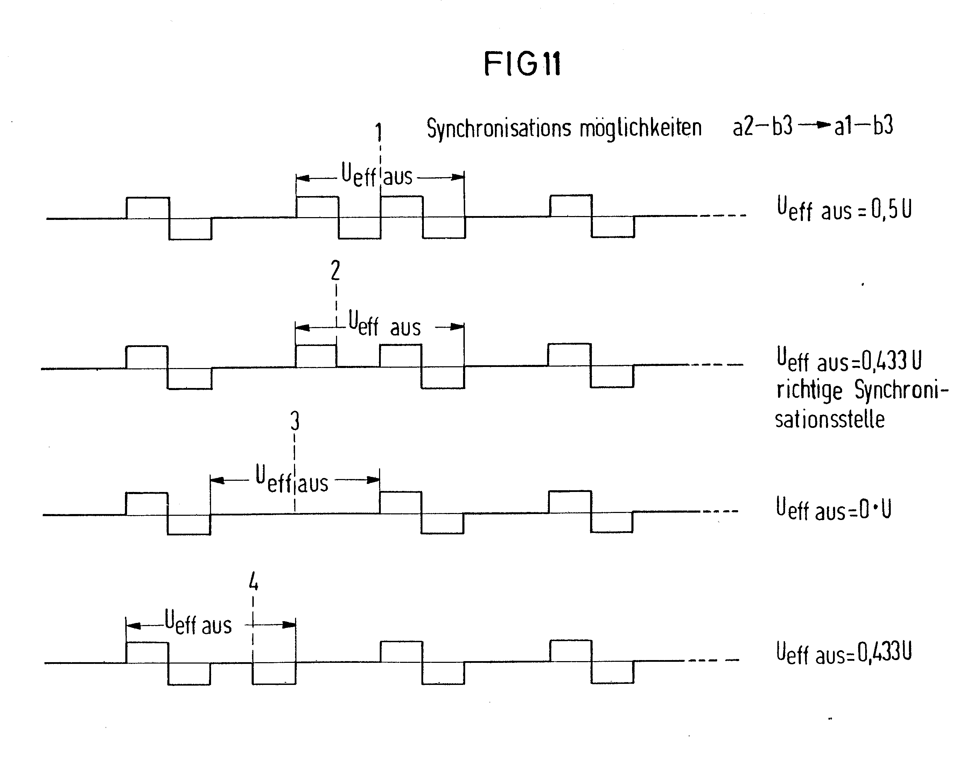

Um den Grundwellenanteil der Differenzspannungen niedrig zu halten, empfiehlt es sich, die Umschaltung von einer Spannungskurvenform zu einer anderen Spannungskurvenform synchron an den Stellen 1, 2, 3 und 4 (Fig. 5) vorzunehmen. Alle Möglichkeiten hierzu sind in den Figuren 6 bis 11 dargestellt. Dabei ergibt sich, daß um den Synchronisationspunkt herum kurzzeitig für eine Periode der Effektivwert der Spannung gegenüber dem periodischen Effektivwert ein Minmum bzw. ein Maximum aufweisen kann. Dieses würde bei der Balken-LCD-Anzeige zu dem erwähnten Flackern führen. Um diese Extremata zu reduzieren, ist es angebracht, die Umschaltung auf die aus Figur 5 ersichtlichen Synchronisierungsstellen zu beschränken.

Bei dem günstigsten Synchronisationszeitpunkt treten im ungünstigsten Fallkurzzeitig beim Wechsel von einer Spannungskurvenform zu einer anderen folgende maximale Effektivspannungswerte auf:

Wechsel von $a_1$ nach $a_2$ bei gleichbleibender Spannungsform b :

$$U_{eff\ EIN_{max}} = [((U^2 t/4) + U^2 3t)/4t]^{1/2} = \{13U^2/16\} = 0{,}901\ U \triangleq$$
$$\triangleq a_1\text{-}b_1 \text{ nach } a_2\text{-}b_1;$$

$$U_{eff\ AUS_{max}} = [(U^2 3t)/4t]^{1/2} = (3U^2/16)^{1/2} =$$
$$= 0{,}433U \triangleq a_1\text{-}b_3 \text{ nach } a_2\text{-}b_3.$$

Das Verhältnis $U_{eff\ EIN\ max} : U_{eff\ AUS\ max}$ beträgt 2,08 demzufolge.

$$U_{eff\ EIN_{max}} = [((U^2 t/4) + U^2 2t)/4t]^{1/2} = (9U^2/16)^{1/2} = 0{,}75U \triangleq a_1\text{-}b_2 \text{ nach } a_2\text{-}b_2,$$
$$U_{eff\ EIN\ max} : U_{eff\ AUS\ max} = \sqrt{3}.$$

Wechsel von $a_2$ nach $a_1$ bei gleichbleibender Spannungsform b:

$$U_{eff\ EIN_{max}} = [((U^2 t/4) + U^2 3t)4t]^{1/2} = (13U^2/16)^{1/2} =$$
$$= 0{,}901U \triangleq a_2\text{-}b_1 \text{ nach } a_1\text{-}b_3;$$

0058756

$$U_{eff\,AUS_{max}} = [((U^2 3t)4)4t]^{1/2} = (3u^2/16)^{1/2} = 0,433 \;\hat{=}$$
$$\hat{=} a_2 - b_3 \text{ nach } a_1-b_3;$$

und damit

$$U_{eff\,EIN\,max} : U_{eff\,AUS\,max} = 2,08;$$

$$U_{eff\,EIN_{max}} = [((U^2 t)4) + U^2 2t)/4t]^{1/2} = (9U^2/16)^{1/2} =$$
$$= 0,433U \;\hat{=} a_2-b_2 \text{ nach } a_1-b_2$$

und

$$U_{eff\,EIN\,max} : U_{eff\,AUS\,max} = (3)^{1/2}.$$

Man erkennt aus der soeben gebrachten Darstellung, daß die aus Figur 5 ersichtlichen und dort als günstige Synchronisationszeitpunkte bezeichneten Zeitpunkte 2 tatsächlich bei Anwendung des Zweischritt-Multiplexverfahrens am günstigsten sind. Die in Figur 3 dargestellte Steueranlage gemäß der Erfindung für eine LCD-Balkenanzeigeeinheit erfüllt, wie aus Fig. 4 ersichtlich ist, die Übernahme in einem solchen günstigen Synchronisierungszeitpunkt zwangsläufig.

Verständlicherweise läßt sich die in Figur 3 dargestellte Anlage auch auf ein Dreischritt- bzw. Vierschritt-Multiplex-Verfahren abstimmen. Dabei zeigt eine Übertragung der soeben gebrachten Betrachtungen, daß sich auch in diesen Fällen ein optimaler Synchronisiationszeitpunkt ausfindig machen läßt, der das Flackern beim Umschalten der Anzeigeeinheit unterbindet.

11 Figuren

Patentansprüche

1.) Monolithisch integrierbare Steuerschaltung für den Multiplexbetrieb einer insbesondere für die Balkenanzeige geeigneten LCD-Anzeigeeinheit, dadurch gekennzeichnet, daß die zur Beaufschlagung der - mehrere Steuerelektroden aufweisenden - LCD-Anzeigeeinheit vorgesehene Multiplexanlage (MUX) ihrerseits durch - zur Anzeigesteuerung über einen Zwischenspeicher (ZS) zugeführte - informationstragende digitale Steuersignale und andererseits über einen taktgesteuerten Kurvengenerator (KG) zwecks Formung der Amlitude der an die Steuerelektroden (X1,..XN; Y1...YM) der Anzeigeeinheit effektiv zu legenden Steuersignale (A1, A2;B1, B2, B3) gesteuert ist und daß außerdem ein die über den Kurvengenerator (KG) und andererseits über den Zwischenspeicher (ZS) zugeführten Signale synchronisierender Schaltungsteil (SY) vorgesehen ist.

2.) Steuerschaltung nach Anspruch 1, dadurch gekennzeichnet, daß ein Taktgenerator (TG) mit mehreren und zeitmäßig aufeinander abgestimmte Digitalimpulse liefernden Ausgängen zur Steuerung des Kurvengenerators (KG) sowie der Synchronisierschaltung (SY) vorgesehen und der Ausgang der Synchronisierungsschaltung (SY) zur Steuerung der Übergabe der im Zwischenspeicher (ZS) jeweils anhängigen digitalen Information an die Multiplexanlage (MUX) vorgesehen ist.

3.) Steuerschaltung nach Anspruch 1 oder 2, dadurch gekennzeichnet, daß die Synchronisierschaltung (SY) einen durch ein extern zugeführtes Übernahmesignal (ÜB) zu beaufschlagenden weiteren Steuereingang besitzt.

4.) Steuerschaltung nach einem der Ansprüche 1 bis 4, dadurch gekennzeichnet, daß die zur Auslösung der von dem Kurvengenerator (KG) an den Multiplexer (MUX) die-

0058756

nenden und vom Taktgenerator (TG) gelieferten digitalen Steuerimpulse zugleich an je einen Steuereingang der Synchronisierschaltung (SY) gelegt sind.

5.) Steuerschaltung nach einem der Ansprüche 1 bis 4, dadurch gekennzeichnet, daß die Synchronisieranlage (SY) durch ein logisches Gatter vom UND-Typ bzw. vom NICHT-ODER-typ gegeben ist.

6.) Steuerschaltungnach einem der Ansprüche 1 bis 5, dadurch gekennzeichnet, daß die Steuerschaltung in MOS-Technik, insbesondere in CMOS-Technik, realisiert ist.

7.) Steuerschaltung nach einem der Ansprüche 1 bis 6, dadurch gekennzeichnet, daß die Schaltung auf den Zweischritt-Multiplex-Betrieb ausgerichtet ist.

8.) Steuerschaltung nach Anspruch 8, dadurch gekennzeichnet, daß der Taktgenerator (TG) aus einer Teilerkette mit 5 Teilerstufen (A,B,C,D,E) besteht, die von einem periodische Rechteckimpulse abgebenden Oszillator, insbesondere einem RC-Oszillator (IM) gesteuert ist.

9.) Steuerschaltung nach Anspruch 5 oder 8, dadurch gekennzeichnet, daß je ein Ausgang jeder Teilerstufe zur Steuerung je eines Eingangs des den Synchronisierer (SY) bildenden logischen Gatters vorgesehen ist.

10.) Steuerschaltung nach einem der Ansprüche 1 bis 9, dadurch gekennzeichnet, daß eine taktgesteuerte Speicherzelle (SZ) zur Steuerung eines zweiten Teiles (t1 -t8) des Kurvengenerators (KG) vorgesehen ist, die ihre Taktsignale vom Taktgeber und ihre Information teils vom Taktgenerator (TG) teils vom ersten Teil T1 - T12) des Kurvengenerators (KG) erhält und daß sowohl die vom ersten Teil des Kurvengenerators (KG) an den zweiten Teil des Kurvengenerators (KG) gelieferten Signale (B1, B2, B3) als auch die vom zweiten Teil des Kurvengenerators (KG) gelieferten Signale (A1, A2) zur Steuerung der Multiplexanlage (MUX) verwendet sind.

# FIG 1

FIG 2

FIG 3

FIG3a

X-Mutiplexer

FIG3b

Y-Multiplexer

FIG 4

EQ̄

EQ

DQ̄

DQ

CQ̄

CQ

BQ̄

BQ

AQ̄

B1

B2

B3

SZQ

A1

A2

ÜB

SY

SY

# FIG5

0058756

# FIG 6

Synchronisations möglichkeiten  a1-b1 ⟶ a2-b1    immer ein

$U_{eff\ ein} = U$

$U_{eff\ ein} = 0,901\,U$
richtige Synchronisationsstelle

$U_{eff\ ein} = 0,5\,U$

$U_{eff\ ein} = 0,901\,U$

# FIG 7

Synchronisations möglichkeiten  a1-b2 → a2-b2
Wechsel von "Ein" nach "Aus" bezw. umgekehrt

0,79t

0,75t  richtige
Synchronisationsstelle

0,79t

0,66t

0058756

# FIG 8

Synchronisations möglichkeiten   a1-b3 ⟶ a2-b3
immer "Aus"

$U_{eff\ aus} = 0 \cdot U$

$U_{eff\ aus} = 0,43\ U$
richtige Synchronisationsstelle

$U_{eff\ aus} = 0,5\ U$

$U_{eff\ aus} = 0,43\ U$

# FIG 9

Synchronisations möglichkeiten   a2 - b1 → a1 - b1

$U_{eff\,ein}$ = 0,5 U

$U_{eff\,ein}$ = 0,901 U
richtige Synchronisationsstelle

$U_{eff\,ein}$ = U

$U_{eff\,ein}$ = 0,66 U

0058756

# FIG 10

Synchronisations möglichkeiten   a2 - b2 → a1 - b2

$U_{eff\,ein}$ = 0,66 U

$U_{eff\,ein}$ = 0,75 U
richtige Synchronisationsstelle

$U_{eff\,ein}$ = 0,79 U

$U_{eff\,ein}$ = 0,66 U

11/12

0058756

# FIG 11

Synchronisations möglichkeiten    a2—b3 ⟶ a1—b3

$U_{eff}$ aus = 0,5 U

$U_{eff}$ aus = 0,433 U
richtige Synchronisationsstelle

$U_{eff}$ aus = 0·U

$U_{eff}$ aus = 0,433 U

0058756

## EINSCHLÄGIGE DOKUMENTE

| Kategorie | Kennzeichnung des Dokuments mit Angabe. soweit erforderlich. der maßgeblichen Teile | Betrifft Anspruch | KLASSIFIKATION DER ANMELDUNG (Int. Cl ³) |
|---|---|---|---|
| A | DE-A-2 403 172 (SUNCRUX RESEARCH) <br> * Figuren 6,10; Anspruch 1; Seite 13, Zeilen 1-5 * | 1,2,8-10 | G 01 R 13/40 |
| A | US-A-3 955 187 (J.E. BIGELOW) <br> * Spalte 3, Zeilen 66-68 * & DE - A - 2510750 | 1 | |
| A | DE-A-2 400 910 (HITACHI) <br> * Seite 14, erster Absatz * | 1 | |
| A | GB-A-2 036 403 (HITACHI) <br> * Figur 2; Anspruch 1 * | 1 | |
| A | US-A-4 060 802 (K. MATSUKI) <br> * Figur 2 * | 6 | |

RECHERCHIERTE SACHGEBIETE (Int. Cl. ³)

G 01 R 13/00
G 02 F 1/00

Der vorliegende Recherchenbericht wurde für alle Patentansprüche erstellt.

| Recherchenort <br> DEN HAAG | Abschlußdatum der Recherche <br> 28-04-1982 | Prüfer <br> GROTZINGER J.P. |
|---|---|---|